# EUROPEAN PATENT SPECIFICATION

(11) **EP 0 731 485 B1**
(45) Date of publication and mention of the grant of the patent: **21.07.1999**
(21) Application number: 96103686.0
(22) Date of filing: 08.03.1996
(51) Int. Cl.: H01J 9/227

(54) **Exposure equipment for display tube fabrication**
Belichtungsvorrichtung für die Herstellung einer Bildschirmröhre
Equipement d'exposition pour la fabrication d'un tube-image

(30) Priority: 08.03.1995 JP 4886695
(43) Date of publication of application: 11.09.1996
(73) Proprietor: MATSUSHITA ELECTRIC INDUSTRIAL CO., LTD., Kadoma-shi, Osaka 571-0050 (JP)
(72) Inventor: Nagano, Hiroyuki, Katano-shi, Osaka 576 (JP); Inoue, Takashi, Sakai-shi, Osaka 590-01 (JP); Ueno, Kazuo, Neyagawa-shi, Osaka 572 (JP); Mochida, Shohroh, Neyagawa-shi, Osaka 572 (JP); Ueda, Shuji, Katano-shi, Osaka 576 (JP); Adachi, Osamu, Osaka-shi, Osaka 533 (JP)
(74) Representative: Grünecker, Kinkeldey, Stockmair & Schwanhäusser Anwaltssozietät

(56) References cited:
- EP-A- 0 382 308
- DE-A- 2 755 294
- US-A- 3 504 599

## Description

### II. FIELD OF THE INVENTION

The present invention relates to exposure equipment that is used in fabrication of display tubes such as CRT (cathode ray tube) and the like. EP-A-0 382 308 discloses such exposure apparatus.

### III. BACKGROUND OF THE INVENTION

Fluorescent dots of a display tube are formed by exposing a photoresist comprised of fluorescent materials that was applied to the inner surface of the display tube to light through a mask having a specified dot pattern, and then eliminating the photoresist not exposed to light using a solvent. The fluorescent dots exposed to light are hardened and fixed on the inner surface of the display tube. In the case of a color display tube, fluorescent materials of green (G), blue (B) and red (R) are contained in each respective photoresist. One pixel of the color display tube comprises dots of G, B and R. These dots of G, B and R, and also black matrixes (BM) to separate the G, B and R dots from one another for a clear image displaying are formed in succession according to the production process as described in the above.

Fig. 14 and Fig. 15 show an exposure system as used in a prior art production process.
The light from a rod-shaped mercury lamp 30 is diffused through a narrow slit 31 formed horizontally on a cover 29, passes through a lens 32 for an optical correction and a mask 33, and is incident on the exposure area 35 situated on the inner surface of a display tube 34.
Fig. 15 does not show the lens 32 for an optical correction to make the drawing simpler.

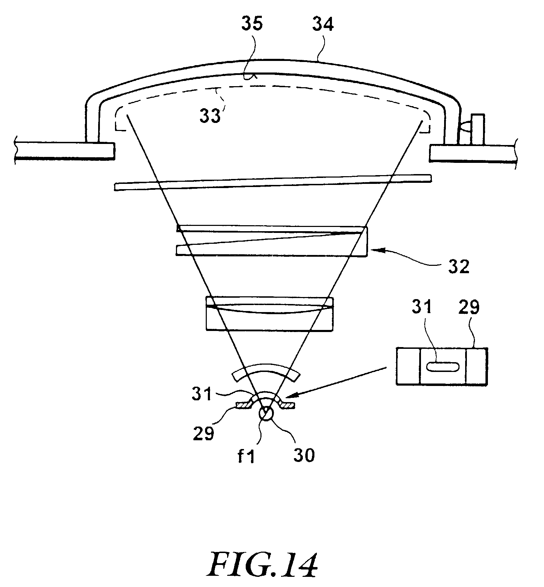

In Fig. 14, how the exposure light is diffused horizontally is illustrated. The exposure light beams are diffused in the horizontal directions from the point of origin f1 for horizontal diffusion, which coincides in position with the center of the mercury lamp 30.

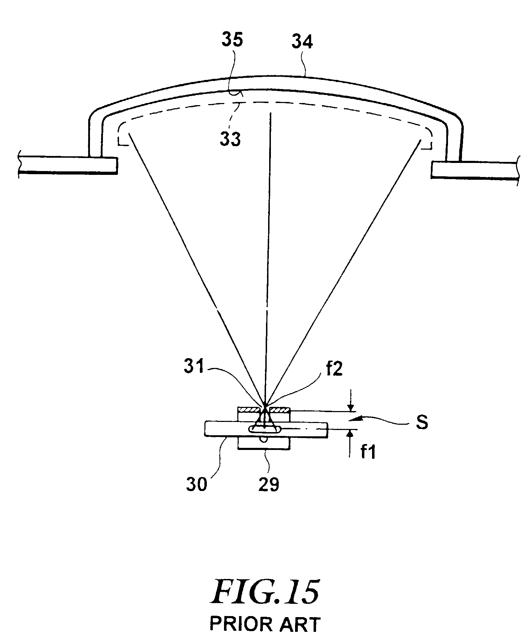

In Fig. 15, how the exposure light is diffused vertically is illustrated. The exposure light beans are diffused in the vertical directions from the point of origin f2 for vertical diffusion located in the slit 31.
The horizontal diffusion angle and vertical diffusion angle of the exposure light beams are established according to the horizontal deflection angle and vertical deflection angle of the electron beams that are made when this display tube is actually put to use, respectively.
When the display tube is actually used, the electron beams are accelerated by a horizontal deflection means and horizontally deflected at the point of origin for horizontal deflection, and at the same time are accelerated by a vertical deflection means and vertically deflected at the point of origin for vertical deflection.
The points of origin for horizontal deflection and vertical deflection as mentioned in the above correspond in position to the positions of the horizontal deflection means and vertical deflection means, respectively.

The points of origin for horizontal diffusion f1 and vertical diffusion f2 of the exposure light as illustrated in Figure 14 and Figure 15 are established so as to coincide with the points of origin for horizontal deflection and vertical deflection, respectively.
Since the horizontal deflection means and vertical deflection means of a display tube usually undergo displacement in the direction of axis, f1 and f2 are also displaced, in the direction of axis by a distance S.

By establishing the positions of f1 and f2 and the diffusion angles of exposure light as described in the above. the exposure light beam to shed light on the dots of G, B and R is projected on each respective exposure area in the same direction as the corresponding deflected electron beam is shed. As a result, the deflected electron beam can sweep accurately over the dots of G, B and R in synchronization with image signals when this display tube is actually used.

However, much of the light radiated from the mercury lamp 30 is blocked by the cover 29 with the prior art exposure equipment as described in the above. The result is that a relatively long exposure time is required due to an insufficient amount of exposure light. The present invention provides exposure equipment that is capable of completing an exposure process in a short period by use of a sufficient amount of exposure light.

### SUMMARY OF THE INVENTION

The present invention provides exposure equipment for display tube fabrication.
The foregoing exposure equipment comprises:
an illuminating means which gathers a light generated from a light source and integrates the gathered light by an optical integrator so that an uniform light is radiated from the illuminating means; and
a lens system whereby the spot light is diffused and the diffused light is projected on the exposure area of a display tube.

The lens system as mentioned in the above has astigmatism, thereby forming a first virtual focus and a second virtual focus in its virtual image area.

The foregoing first and second virtual focuses are located at positions corresponding to those of a vertical and horizontal deflection means of this display tube, respectively.

The exposure light is apparently diffused vertically at the first virtual focus and diffused horizontally at the second virtual focus.

The exposure light beam to shed light on the dots of G, B and R is projected on the exposure area of the display tube by the foregoing lens system in the same direction as the deflected electron beam is shed. Said lens system has astigmatism that provides the first virtual focus and second virtual focus in its virtual image area.
As a result, the deflected electron beam can sweep accurately over the dots of G, B and R in synchronization with image signals when this display tube is actually put to use.

The exposure equipment of the present invention uses almost all the light radiated from the light source effectively for light exposure, thereby making a high brightness exposure possible. Therefore, the time required for exposure is greatly shortened and fabrication cost of display tubes is reduced.

A rod-shaped optical integrator made of glass is used in the exemplary embodiment of the present invention.
The function of the foregoing rod-shaped optical integrator is to integrate the incident light by reflecting light repeatedly in its interior and radiate light with a uniform distribution of light intensity.

The rod-shaped optical integrator as described in the above has benefits of being compact in size and low in cost.

### BRIEF DESCRIPTION OF THE DRAWINGS

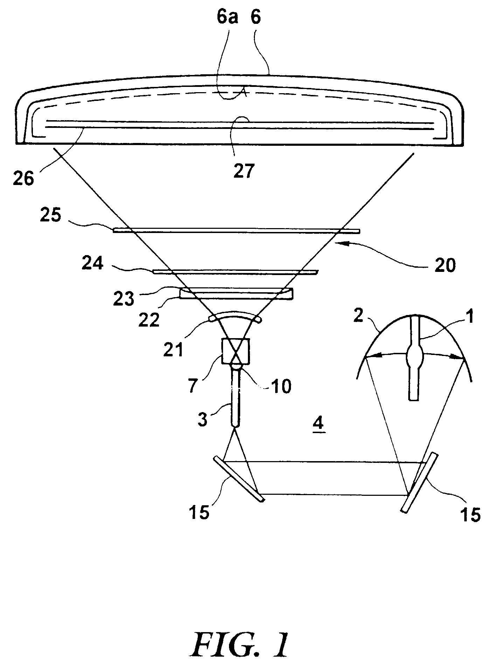

Fig. 1 shows exposure equipment as an exemplary embodiment of Example 1 of the present invention.

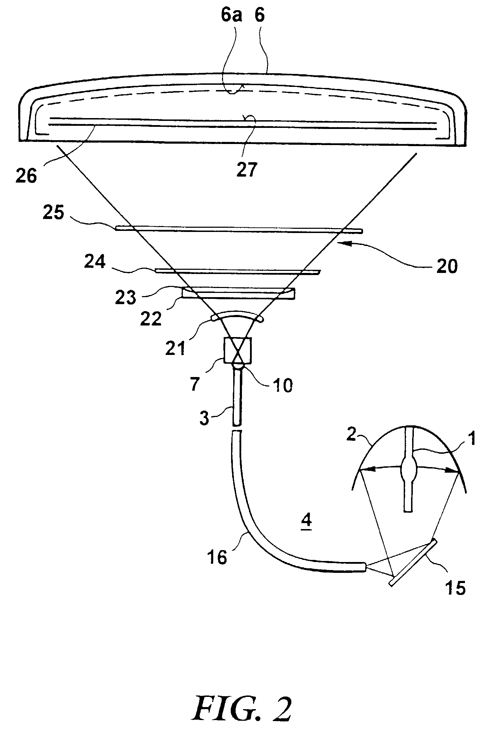

Fig. 2 shows exposure equipment as another exemplary embodiment of Example 1 of the present invention, wherein an optical fiber is used to transmit the gathered light.

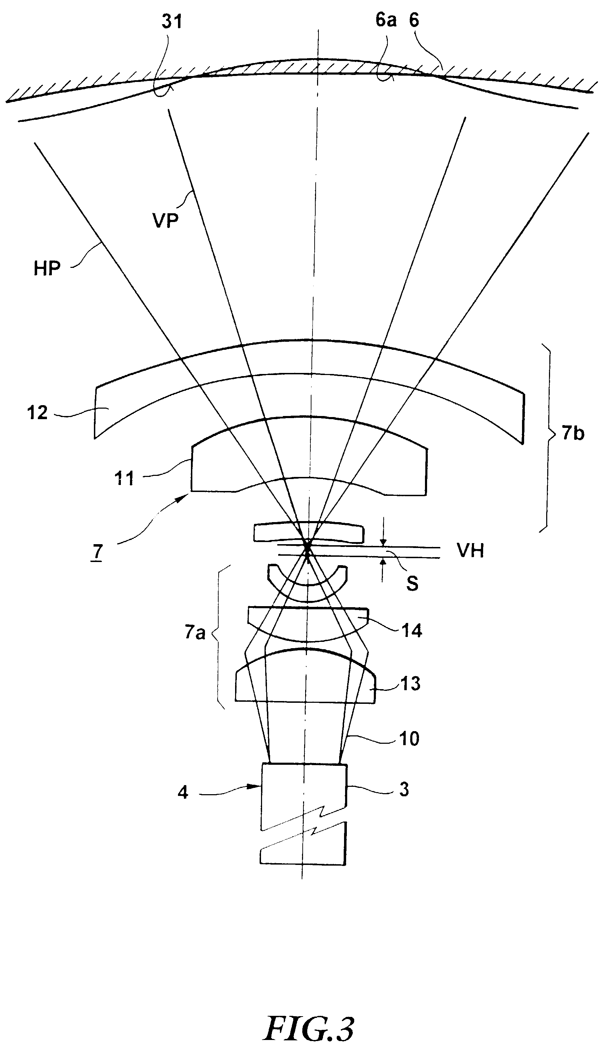

Fig. 3 shows a lens system to diffuse the exposure light.

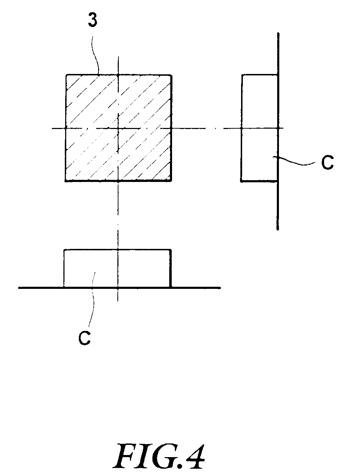

Fig. 4 shows radiant light from an optical integrator. The radiant light is uniform in its light intensity distribution due to light integration performed within the optical integrator.

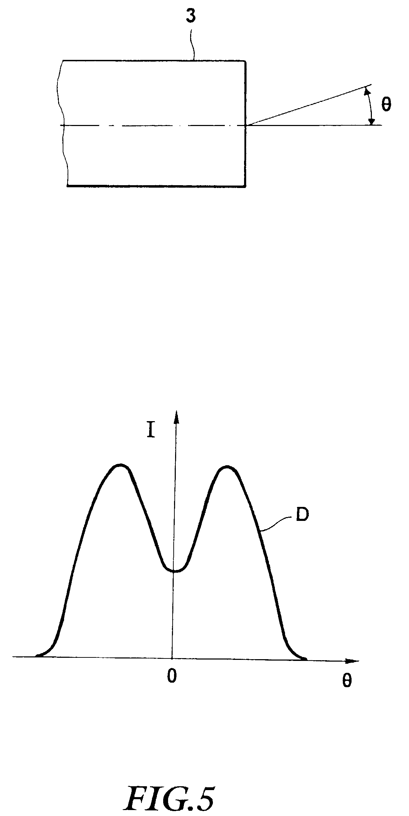

Fig. 5 shows the relation between radiant angle θ and light intensity I from the optical integrator.

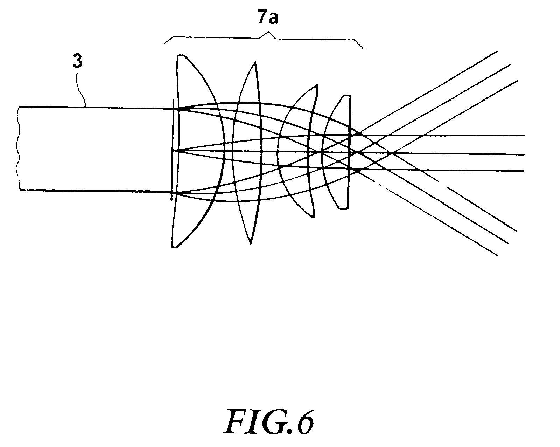

Fig. 6 shows radiant light from a telecentric lens system.

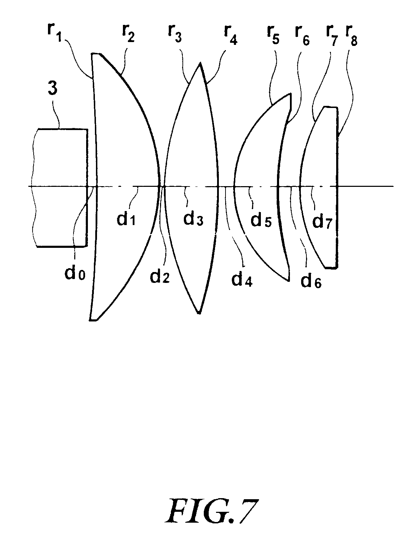

Fig. 7 shows a telecentric lens system.

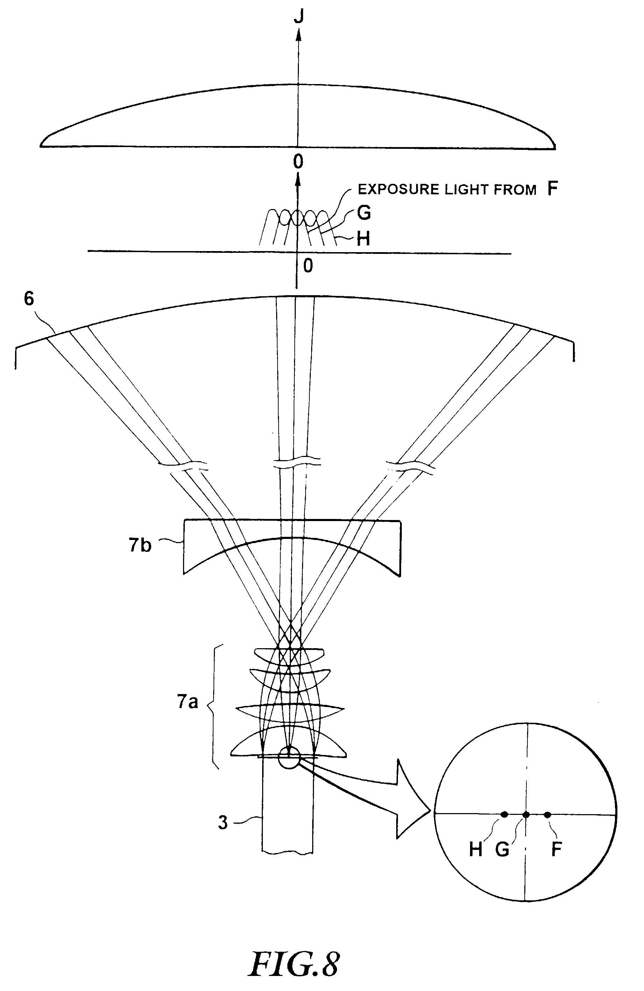

Fig. 8 shows light intensity distribution on an exposure area integrating radiant light from a radiant point of an optical integrator.

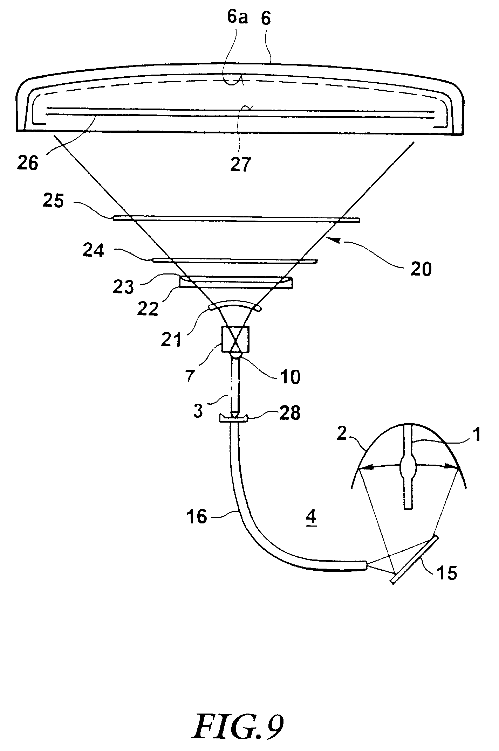

Fig. 9 shows exposure equipment of Example 3 of the present invention.

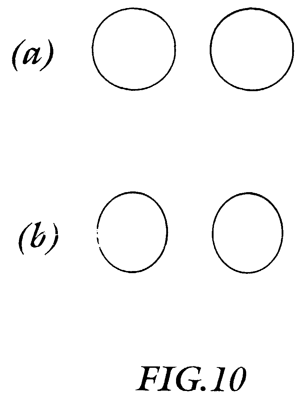

Fig. 10 shows an exposed shape on an exposure area.

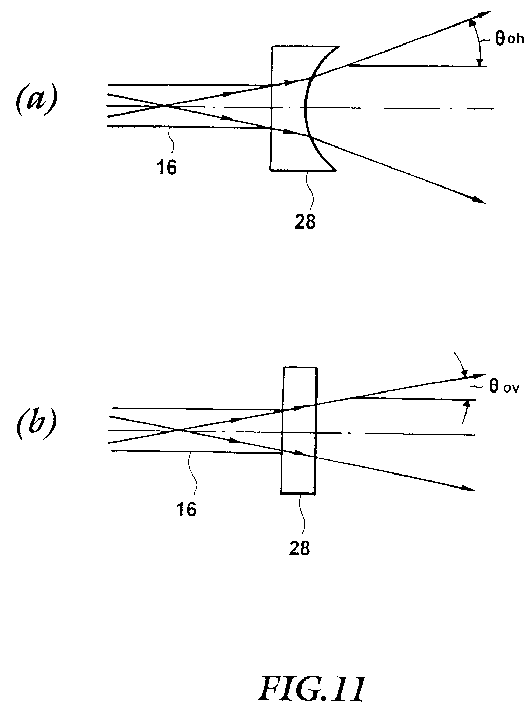

Fig. 11 shows lens shape of an exposure correction lens system and radiant angle along horizontal and vertical directions.

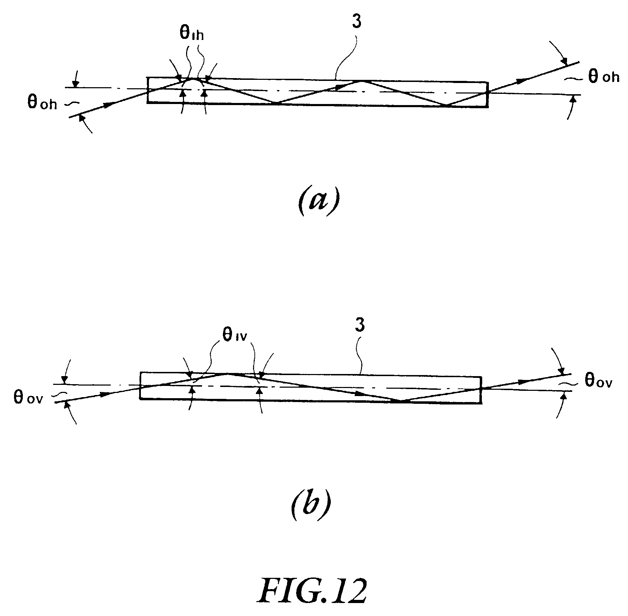

Fig. 12 shows how light is incident on one end of an optical integrator and irradiates from the other end.

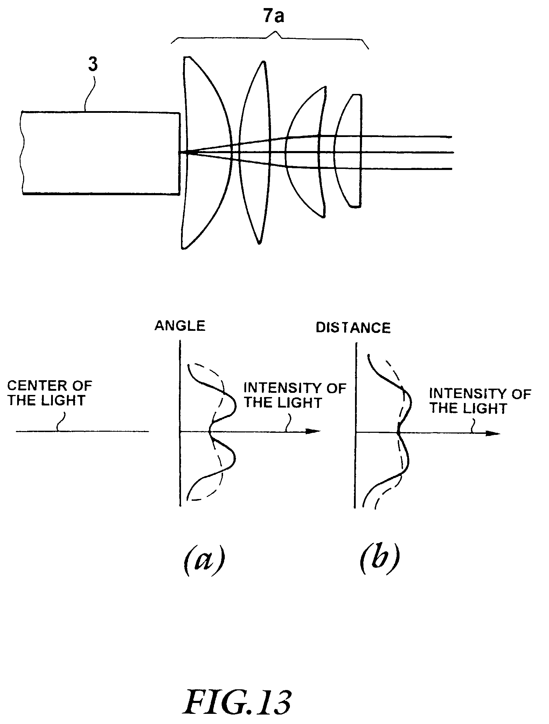

Fig. 13 shows light intensity distribution dependency on radiant angle irradiated from an optical integrator and light intensity distribution dependency on distance from the center axis of light irradiated from a telecentric lens system.

Fig. 14 shows how a horizontal light exposure is performed according to a prior art.

Fig. 15 shows how a vertical light exposure is performed according to a prior art.

### DETAILED DESCRIPTION OF THE INVENTION

### (Example 1)

Fig. 1 shows exposure equipment as an exemplary embodiment of the present invention.
This exposure equipment is provided with an illumination means 4 and a lens system 7.
In the illumination means 4, light radiated from an ultra-high voltage mercury lamp 1 is focused by means of an oval mirror 2. The focused light is reflected by a cold mirror 15 and then incident on one end of a rod-shaped light integrator 3 made of rod-shaped glass, quartz glass and the like, wherein light is integrated by repeated reflections that take place inside the rod-like structure.
Then, the integrated uniform light is radiated from the other end of the light integrator 3.
The lens system 7 projects the light 10 radiated from the light integrator 3 on the exposure area 6a of a display tube 6.

Fig. 2 shows an illumination means 4 as another exemplary embodiment of the present invention.
The light focused by means of an oval mirror 2 is reflected by a cold mirror 15 and incident on one end of a rod-shaped optical integrator 3 after passing through an optical fiber 16.
The optical fiber 16 serves a useful function in preventing interference caused by light from other sources and also in locating the oval mirror 2 at a position so that the exposure equipment is made much smaller.

The rod-shaped optical integrator 3 integrates the incident light by repeated reflections within its interior and radiates light with a uniform distribution C of light intensity as shown in Fig. 4.
The optical integrator of Fig. 4 has a square-shaped cross-section, but it is also possible to make it in a different shape like a triangle or a circle, for example.
The optical integrator 3 can be replaced by a combined assembly of a fly eye lens and an aspheric mirror.
However, the rod-shaped optical integrator 3 having a simpler structure is more beneficial in terms of compactness and low cost.

The light radiated from the optical integrator 3 is projected on the exposure area 6a of the display tube 6 by the lens system 7.
An optical correction means 20 comprised of a cylindrical lens 21, a P lens 22, an X axis filter 23, a S lens 24, an S correction filter 25, a main filter 26 and an ND filter 27 is placed between the lens system 7 and the exposure area 6a.
Since the exposure equipment of the present invention uses effectively almost all the light radiated from the light source for the purpose of exposure, it has become possible to achieve a high brightness exposure.
As a result, the time required for exposure is made much shorter and production costs of display tubes are reduced.

Fig. 3 shows the lens system 7 comprised of an aperture lens 7a and a projection lens 7b.
The aperture lens 7a focuses the light from the illumination means 4 into a spot light having a specified shape that is suitable for exposure.
An aperture means that adjusts the lens opening to a specified shape can be inserted in this aperture lens 7a, if so desired.
The projection lens 7b projects the light gathered by the aperture lens 7a on the exposure area 6a of the display tube 6.
The projected light is composed of vertical diffusion light VP that diffuses in the direction of vertical deflection and horizontal diffusion light HP that diffuses in the direction of horizontal deflection.
The lens system 7 has astigmatism so that the points of origin V and H for virtual images are formed in its virtual image area.
As shown in Fig. 3, the vertical diffusion light VP and horizontal diffusion light HP are apparently diffused from V and H, respectively, because V and H serve as the points of origin for virtual images.

The foregoing positions V and H serving as the points of origin for virtual images are arranged so as to correspond to the points of origin for electron beams' vertical deflection and horizontal deflection, respectively.
Furthermore, the horizontal and vertical diffusion angles of the exposure light are formed to correspond to the electron beams' horizontal and vertical deflection angles of this display tube when this display tube is actually put to use, respectively. Therefore, the beams of the vertical diffusion light VP and horizontal diffusion light HP are projected on the exposure area of the display tube in the same directions as the electron beams that have been deflected vertically and horizontally, respectively. As a result, when this display tube is actually put to use, the deflected electron beams can sweep over the dots G, B and R accurately in synchronization with image signals.
The foregoing points of origin V and H for virtual images are displaced by a distance S corresponding to the displacements of the electron beams' vertical and horizontal defelction means.
Since the vertical deflection means is located closer to the light integrator 3 than the horizontal deflection means in the present exemplary embodiment, the point of origin V for virtual image is arranged closer to the aperture integrator 3 than the point of origin H for virtual image.
If the positions of the vertical deflection means and horizontal deflection means are reversed, the positions of the point of origin V for virtual image and point of origin H for virtual image will be also reversed.

A variety of lens designs can realize the points of origin V and H for virtual images as described in the above.
In Fig. 3, the point of origin V for virtual image is realized by a combination of anamorphic lenses 13 and 14, and the point of origin H for virtual image is realized by a combination of anamorphic lenses 11 and 12.
Various kinds of lens design such as cylindrical lens, toroidal lens, toric lens and the like, for example, can be used to make the anamorphic lenses 11 to 14.
In the case of a display tube of 21 inches in size (448 mm in horizontal width) for example, a good result was obtained by the following specifications:
The distance between the tip of optical integrator 3 and the exposure surface = 32.5 mm
The horizontal diffusion angle of exposure light = 36°
The vertical diffusion angle of exposure light = 24°
The positional displacement of the points of origin V and H for virtual images = 7 mm
Dimensions of the optical integrator = 6 mm square
The light gathered by the aperture lens 7a = 2 mm square

The exposure light sometimes forms images on a deformed imaging surface 31, resulting in nonuniform light exposure. An ND filter 27 as shown in Fig. 1 corrects the foregoing nonuniform light exposure in concert with a main filter 26 installed to correct nonuniformity in exposure in the periphery and also the central part of the imaging surface.

Furthermore, the main filter 26 corrects nonuniform light exposure so that the nonuniformity does not hurt the practical use of the display tube even when the exposure light used does not focus correctly on the exposure area 6a.

### (Example 2)

When radiant light from optical integrator 3 has the light intensity dependency on radiant angle as shown in distribution D of Fig. 5, a telecentric lens system is preferable as an aperture lens.

As shown in Fig. 6, the telecentric lens system of an aperture lens converts the radiant light from respective point within a specified radiant angle of an optical integrator to a parallel light flux.

As a result, all the exposure area can be exposed in a smooth light intensity J as shown in Fig. 8.

Fig. 7 shows an example of a telecentric lens system. The focus distance is 6.7 mm and F number is 2.37. The following table shows design dimensions.

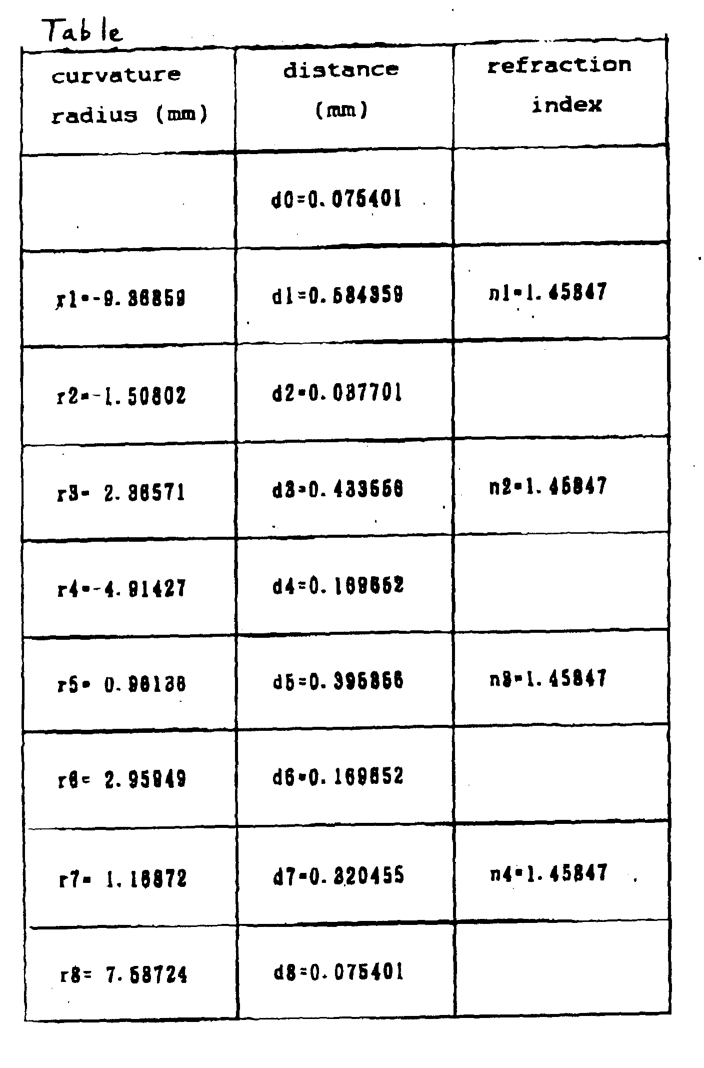

### (Example 3)

Figure 9 shows exposure equipment of Example 3 of the present invention. An exposure shape correction lens system 28 comprised of a cylindrical lens is disposed before the incident end of optical integrator 3.

When a same mask which is used for a conventional exposure equipment is used for the exposure equipment of the present invention, the exposed shape on an exposure area 6a does not become a desired one as shown in Fig 10(a) but it happens to become thin along horizontal direction as shown in Fig. 10(b).

In this case, the exposure correction lens 28 realizes a desired shape.
Figure 11 shows the radiant light from the exposure correction lens 28 comprised of a cylindrical lens. Fig. 11(a) shows radiation along horizontal direction and Fig. 11(b) along vertical direction.

It is possible to make the horizontal radiant angle θ0h larger than the vertical radiant angle θ0v by changing the shape of the exposure correction lens 28.

The light is incident on one end of optical integrator 3 at an incident angle of θ0h and θ0v described above and repeats reflection at the inner side of optical integrator and is integrated.

As shown in Fig. 12(a) and (b), the advance angles θ1h and θ1v do not change by repeating reflection at the inner side of optical integrator.
The radiant light is irradiated from the other end of optical integrator at an radiant angle same as the incident angle θ0h and θ0v.

Thus, the horizontal light intensity distribution of radiant light from optical integrator 3 changes from a solid line to a dotted line shown in Fig. 13 (a) in relation to radiant angle.
The radiant light irradiated from a telecentric lens of an aperture lens system shown in Fig. 13(b).
Fig. 13(b) shows the horizontal light intensity distribution in relation to the distance from the center axis of light.

The exposure distance toward horizontal direction increases and the exposed shape becomes desirable as shown in Fig. 12(a).

In the present Example, the exposure shape correction lens 28 is composed of a cylindrical lens.
It is of course that an anamorphic lens can also be used as an exposure shape correction lens.

## Claims

1. Exposure equipment for display tube fabrication comprising:
an illuminating means (4) which gathers a light generated from a light source (1) and integrates the gathered light by an optical integrator (3) so that a uniform light is radiated from the illuminating means; and
a lens system (7) whereby the radiated light (10) from the illuminating means (4) is diffused and the diffused light is projected on the exposure area (6a) of a display tube (6) with said lens system (7) presenting astigmatism;
thereby forming a first virtual focus (V) and a second virtual focus (H) in its virtual image area, said first and second virtual focuses being located at positions corresponding to those of a vertical and horizontal deflection means of this display tube (6), respectively;
wherein the exposure light is apparently diffused vertically at the first virtual focus (V) and diffused horizontally at the second virtual focus (H).

2. Exposure equipment according to claim 1, **characterized in that** the lens system (7) is provided with an aperture lens (7a), which transfers the radiated light from the optical integrator (3) into a spot light having a predetermined size composed of a parallel light flux, and
a projection lens (7b), which projects the light from the aperture lens (7a) on the exposure area (6a) of the display tube (6).

3. Exposure equipment of claim 2, **characterized in that** said illuminating means (4) comprises:
light gathering means (2) which gathers the light generated from the light source (1);
a rod shaped optical integrator (3) which receives the gathered light at its one end, integrates the received light and radiates the integrated light (10) from another end.

4. Exposure equipment of claim 3, **characterized in that** said illuminating means (4) further comprises:
an optical fiber (16) for transmitting the gathered light from the light gathering means (2) to the optical integrator (3).

5. Exposure equipment of one of the claims 3 and 4, **characterized in that** the aperture lens (7a) is comprised of a telecentric optical system.

6. Exposure equipment of one of the claims 3 and 4, **characterized in that** said illuminating means (4) further comprises:
an exposure shape correction lens system (28) before the incident end of the optical integrator (3), said exposure shape correction lens system (28) including an anamorphic lens system which changes optical characteristics along horizontal and vertical directions of the gathered light.

7. Method for exposing the display area (6a) of the display tube (6) in display tube fabrication, comprising the steps of:
(a) gathering a light generated from a light source (1),
(b) integrating the gathered light for radiating a light having uniform intensity,
(c) focusing the radiated light to the spot having a specific size,
(d) projecting the spot light on the display area (6a) of the display tube (6) by diffusing the spot light apparently from two origins (V,H) which are located respectively at positions corresponding to those of a vertical and horizontal deflection means of this display tube (6) by the use of a lens system (7) having astigmatism.

## Patentansprüche

1. Belichtungsvorrichtung zur Herstellung von Bildröhren, umfassend:
eine Belichtungseinrichtung (4), die ein Licht, das von einer Lichtquelle (1) erzeugt wird, sammelt und das gesammelte Licht mit Hilfe eines optischen Integrators (3) integriert, so daß ein gleichmäßiges Licht von der Belichtungseinrichtung ausgestrahlt wird; und
ein Linsensystem (7), wodurch das von der Belichtungseinrichtung (4) ausgestrahlte Licht (10) diffus gemacht wird und das diffuse Licht auf die Belichtungsfläche (6a) einer Bildröhre (6) projiziert wird, wobei das Linsensystem (7) einen Astigmatismus aufweist;
wodurch ein erster virtueller Fokus (V) und ein zweiter virtueller Fokus (H) in seiner virtuellen Bildfläche gebildet wird, wobei der erste und zweite virtuelle Fokus an Stellen angeordnet sind, die jeweils denen einer vertikalen und horizontalen Ablenkeinrichtung der Bildröhre (6) entsprechen;
wobei das Bestrahlungslicht scheinbar an dem ersten virtuellen Fokus (V) vertikal diffus gemacht wird und an dem zweiten virtuellen Fokus (H) horizontal diffus gemacht wird.

2. Belichtungsvorrichtung nach Anspruch 1, **dadurch gekennzeichnet, daß** das Linsensystem (7) mit einer Fensterlinse (7a) versehen ist, die das von dem optischen Integrator (3) ausgestrahlte Licht in ein Punktlicht mit einer bestimmten Größe zusammengesetzt aus einem parallelen Lichtfluß transferiert, und
einer Projektionslinse (7b), die das Licht von der Fensterlinse (7a) auf die Belichtungsfläche (6a) der Bildröhre (6) projiziert.

3. Belichtungsvorrichtung nach Anspruch 2, **dadurch gekennzeichnet, daß** die Belichtungseinrichtung (4) umfaßt:
eine Lichtsammeleinrichtung (2), die das von der Lichtquelle (1) erzeugte Licht sammelt;
einen stabförmigen optischen Integrator (3), der das gesammelte Licht an seinem einen Ende empfängt, das empfangene Licht integriert und das integrierte Licht (10) von dem anderen Ende abstrahlt.

4. Belichtungsvorrichtung nach Anspruch 3, **dadurch gekennzeichnet,** daß die Belichtungseinrichtung (4) weiter umfaßt:
eine optische Faser (16) zum Transmittieren des gesammelten Lichts von der Lichtsammeleinrichtung (2) zu dem optischen Integrator (3).

5. Belichtungsvorrichtung nach einem der Ansprüche 3 oder 4, **dadurch gekennzeichnet,** daß die Fensterlinse (7a) ein telezentrisches optisches System umfaßt.

6. Belichtungsvorrichtung nach Anspruch 3 oder 4, **dadurch gekennzeichnet,** daß die Belichtungseinrichtung (4) weiter umfaßt: ein Korrekturlinsensystem für die Belichtungsform (28) vor dem Einfallsende des optischen Integrators (3), wobei das Korrekturlinsensystem für die Belichtungsform (28) ein Entzerrlinsensystem einschließt, das die optischen Charakteristiken entlang der Horizontal- und Vertikalrichtung des gesammelten Lichts ändert.

7. Verfahren zum Belichten der Bildfläche (6a) der Bildröhre (6) bei der Bildröhrenherstellung, das folgende Schritte umfaßt:
(a) Sammeln eines Lichts, das von einer Lichtquelle (1) erzeugt wird,
(b) Integrieren des gesammelten Lichts, um ein Licht mit gleichmäßiger Intensität abzustrahlen,
(c) Fokussieren des ausgestrahlten Lichts auf einen Punkt mit spezifischer Größe,
(d) Projizieren des Punktlichts auf die Bildfläche (6a) der Bildröhre (6) indem das Punktlicht scheinbar von zwei Ursprüngen (V, H) diffus gemacht wird, die jeweils an Stellen angeordnet sind, die denen einer vertikalen und horizontalen Ablenkeinrichtung der Bildröhre (6) entsprechen, wobei ein Linsensystems (7), das einen Astigmatismus aufweist, verwendet wird.

## Revendications

1. Equipement d'exposition pour la fabrication d'un tube de visualisation comprenant :
des moyens d'éclairage (4) qui collectent une lumière produite à partir d'une source lumineuse (1) et intègrent la lumière collectée au moyen d'un intégrateur optique (3) de telle sorte qu'une lumière uniforme soit émise depuis les moyens d'éclairage ; et
un système de lentilles (7) où la lumière émise (10) depuis les moyen d'éclairage (4) est diffusée et la lumière diffusée est projetée sur la zone d'exposition (6a) d'un tube de visualisation, ledit système de lentilles (7) présentant un astigmatisme ;
formant ainsi un premier foyer virtuel (V) et un second foyer virtuel (H) dans sa zone d'image virtuelle, lesdits premier et second foyers virtuels étant situés à des emplacements correspondant à ceux de moyens de déflexions verticale et horizontale de ce tube de visualisation (6), respectivement ;
dans lequel la lumière d'exposition est apparemment diffusée verticalement au premier foyer virtuel (V) et diffusée horizontalement au second foyer virtuel (H).

2. Equipement d'exposition selon la revendication 1, caractérisé en ce que le système de lentilles (7) est muni d'une lentille à ouverture (7a), qui transforme la lumière rayonnée provenant de l'intégrateur optique (3) en une lumière de spot présentant une taille prédéterminée et composée d'un flux de lumière parallèle, et
une lentille de projection (7b), qui projette la lumière provenant de la lentille à ouverture (7a) sur la zone d'exposition (6a) du tube de visualisation (6).

3. Equipement d'exposition selon la revendication 2, caractérisé en ce que lesdits moyens d'éclairage (4) comprennent :
des moyens collecteurs de lumière (2) qui collectent la lumière produite à partir de la source lumineuse (1) ;
un intégrateur optique en forme de barreau (3) qui reçoit la lumière collectée à l'une de ses extrémités, intègre la lumière reçue et émet la lumière intégrée (10) à partir d'une autre extrémité.

4. Equipement d'exposition selon la revendication 3, caractérisé en ce que lesdits moyens d'éclairage (4) comprennent en outre :
une fibre optique (16) pour transmettre la lumière collectée depuis les moyens collecteurs de lumière (2) à l'intégrateur optique (3).

5. Equipement d'exposition selon l'une des revendications 3 et 4, caractérisé en ce que la lentille à ouverture (7a) comprend un système optique télécentrique.

6. Equipement d'exposition selon l'une des revendications 3 et 4, caractérisé en ce que les moyens d'éclairage (4) comprennent en outre :
un système de lentilles correctrices de forme d'exposition (28) avant l'extrémité d'incidence de l'intégrateur optique (3), ledit système de lentilles correctrices de forme d'exposition (28) comprenant un système de lentilles anamorphiques qui modifie les caractéristiques optiques le long des directions horizontale et verticale de la lumière collectée.

7. Procédé pour exposer la zone de visualisation (6a) du tube de visualisation (6) lors de la fabrication du tube de visualisation, comprenant les étapes consistant à :
(a) collecter une lumière produite à partir d'une source lumineuse (1),
(b) intégrer la lumière collectée pour émettre une lumière ayant une intensité uniforme,
(c) focaliser la lumière rayonnée en spot ayant une taille spécifique,
(d) projeter la lumière de spot sur la zone de visualisation (6a) du tube de visualisation (6) en diffusant la lumière de spot apparemment depuis deux origines (V, H) qui sont situées respectivement à des endroits correspondant à ceux de moyens de déflexions verticale et horizontale de ce tube de visualisation (6) en utilisant un système de lentilles (7) présentant un astigmatisme.
